# EUROPEAN PATENT APPLICATION

(11) **EP 4 803 914 A1**
(43) Date of publication of application: **09.09.2026**
(21) Application number: 26159987.2
(22) Date of filing: 23.02.2026
(51) Int. Cl.: G01R 31/52

(54) **MONITORING SYSTEM FOR AN ELECTRICAL SYSTEM OF AIRFIELD GROUND LIGHTING EQUIPMENT**

(30) Priority: 04.03.2025 FI 20255184
(71) Applicant: Efla Oy, 06150 Porvoo (FI)
(72) Inventor: EINOVAARA, Jaakko, 06150 Porvoo (FI); MATTILA, Janne, 06150 Porvoo (FI); NÄRHI, Pauli, 06150 Porvoo (FI)
(74) Representative: Papula Oy

(57) **Abstract**

Example embodiments provide a system and a method for fault monitoring of an electrical system for airfield ground lighting. The method comprises monitoring current changes occurring in a lighting circuit 308 of the electrical system with a plurality of measurement devices 200 installed to monitor the current without being part of the lighting circuit 308. The method further comprises detecting an indication of a fault in the lighting circuit 308 and a location of the fault based on the current measurements received from the measurement devices 200.

## Description

### TECHNICAL FIELD

The present application generally relates to lighting systems located at airports. Some example embodiments of the present application relate to detection and localization of faults occurring, for example, at runway lighting and other lighting equipment used by aircraft for navigation at airports.

### BACKGROUND

An electrical system of airport ground lighting equipment can comprise a plurality of isolation transformers connected in series and airport lights coupled with the isolation transformers. An airport light may be coupled with a secondary of the isolation transformer. One airport lighting circuit may comprise, for example, 50-100 lights. Further, an airport can have hundreds of lighting circuits.

Locating a fault occurred at such electrical system is cumbersome. There are multiple circuits, long distances and most of the electrical equipment are installed underground. In addition, time windows for performing maintenance are typically short, because maintenance needs to be performed at times with low air traffic, such as at night.

### SUMMARY

This summary is provided to introduce a selection of concepts in a simplified form that are further described below in the detailed description. This summary is not intended to identify key features or essential features of the claimed subject matter, nor is it intended to be used to limit the scope of the claimed subject matter.

Example embodiments may enable detecting and locating faults occurred at an electrical system of an airport ground lighting, such as an electrical system for runway and taxiway lights. Detection of the faults may be based on measurement devices configured to contactlessly measure current at lighting circuits such that the measurement devices are not part of the lighting circuits but can be externally mounted to the lighting circuit. Contactless current measurement may refer to use of a non-contact current sensor, a non-invasive current sensor, a non-galvanic current sensor, or any kind of current sensor capable of performing measurements without having a direct contact with a conductor or braking of the insulation of the conductor being measured. This enables, that the measurement devices can be retrofitted to the electrical system and there is no need to cut wires or make any changes to electrical connections within the lighting circuit.

According to a first aspect, a monitoring system for electrical system of airfield ground lighting is disclosed. The electrical system comprises one or more measurement devices externally mounted to one or more lighting circuits of the electrical system such that the measurement devices are not part of the lighting circuit. The one or more measurement devices are configured to perform measurements of current of a primary cable pair of one or more transformers of the respective lighting circuit by using one or more current sensors configured to measure the current without direct contact with the primary cable pair; and transmit wirelessly, to a remote computing device configured for fault monitoring of the electrical system, data indicative of a difference between input current and output current of the primary cable pair of the respective lighting circuit based on the performed current measurements; the monitoring system further comprising the remote computing device configured to: store information about installation locations of each measurement device at the one or more lighting circuits; store the data received from the one or more measurement devices to a database; detect, based on the data stored in the database, an indication of a fault in the electrical system of the airfield ground lighting based on the difference between the input current and the output current of the primary cable pair; determine a location of the fault within the electrical system based on the location information of the measurement devices associated with the current measurements indicative of the fault; and output information of the detected fault and an indication of the location of the fault within the electrical system to maintenance.

According to an example embodiment of the first aspect, the fault is detected based on the difference exceeding a predefined threshold indicative of a leakage current.

According to an example embodiment of the first aspect, the location of the fault is determined based on the installation locations of the measurement devices associated with a greatest change in the difference indicated by the current measurements.

According to an example embodiment of the first aspect, one or more of the measurement devices further comprises one or more environmental sensors, and said measurement devices are further configured to transmit, to the remote computing device, sensor data about one or more environmental factors associated with the installation location of the respective measurement device; and wherein the remote computing device is further configured to detect, based on the received sensor data of the one or more environmental factors, at least one of an indication of a fault in the electrical system or an indication of an urgency of the fault.

According to an example embodiment of the first aspect, the one or more environmental sensors are configured to monitor at least one of:
- temperature;
- humidity;
- location;
- barometric pressure;
- acceleration; and/or
- light.

According to an example embodiment of the first aspect, a plurality of the measurement devices is installed to the same installation location, and one of the plurality of measurement devices is configured to receive the current measurements from the other measurement devices of said installation location and to transmit the current measurements collectively to the computing device.

According to an example embodiment of the first aspect, the one or more transformers are isolation transformers of lighting units of the airfield ground lighting, and the installation locations comprise an installation location of the isolation transformers.

According to an example embodiment of the first aspect, the installation location is an underground container for an isolation transformer.

According to an example embodiment of the first aspect, the measurement devices are configured to transmit the current measurements continuously or periodically.

According to an example embodiment of the first aspect, at least one of the measurement devices is integrated to an isolation transformer of the one or more lighting circuits.

According to an example embodiment of the first aspect, the location information comprises at least one of geographical coordinates of the measurement device at the airfield, a location of an isolation transformer pit the measurement device is installed to, an identifier of the measurement device or an identifier of a component of the electrical system to which the measurement device is installed to.

According to an example embodiment of the first aspect, the measurement device is configured to perform self-charge inductively from the lighting circuit.

According to a second aspect, an electrical system of airfield ground lighting is disclosed. The electrical system may comprise the monitoring system according to the first aspect.

According to a third aspect, a method for monitoring an electrical system of airfield ground lighting with one or more measurement devices externally mounted to one or more lighting circuits of the electrical system such that the measurement devices are not part of the lighting circuit is disclosed. The method may comprise: performing, by the one or more measurement devices, measurements of current of a primary cable pair of one or more transformers of the respective lighting circuit by using one or more current sensors configured to measure the current without direct contact with the primary cable pair; transmitting wirelessly, by the one or more measurement devices to a remote computing device configured for fault monitoring of the electrical system, data indicative of a difference between input current and output current of the primary cable pair of the respective lighting circuit based on the performed current measurements; storing, by the remote computing device, information about installation locations of each measurement device at the one or more lighting circuits; storing, by the remote computing device, the data received from the one or more measurement devices to a database; detecting, by the remote computing device, based on the data stored in the database, an indication of a fault in the electrical system of the airfield ground lighting based on the difference between the input current and output current of the primary cable pair; determining, by the remote computing device, a location of the fault within the electrical system based on the location information of the measurement devices associated with the current measurements indicative of the fault; and outputting, by the remote computing device, information of the detected fault and an indication of the location of the fault within the electrical system to maintenance.

According to an example embodiment of the third aspect, the fault is detected based on the difference exceeding a predefined threshold indicative of a leakage current.

According to an example embodiment of the third aspect, the location of the fault is determined based on the installation locations of the pair of measurement devices associated with a greatest change the difference indicated by the current measurements.

According to an example embodiment of the third aspect, one or more of the measurement devices further comprises one or more environmental sensors, and said measurement devices are further configured to transmit, to the remote computing device, sensor data about one or more environmental factors associated with the installation location of the respective measurement device; and wherein the remote computing device is further configured to detect, based on the received sensor data of the one or more environmental factors, at least one of an indication of a fault in the electrical system or an indication of an urgency of the fault.

According to an example embodiment of the third aspect, the one or more environmental sensors are configured to monitor at least one of:
- temperature;
- humidity;
- location;
- barometric pressure;
- acceleration; and/or
- light.

According to an example embodiment of the third aspect, the method comprises receiving, from one of the measurement devices from the plurality of measurement devices installed to monitor the same lighting circuit, the current measurements from the other measurement devices of said lighting circuit; and transmitting, by the one of the measurement devices, the current measurements collectively to the computing device.

According to an example embodiment of the third aspect, the installation locations comprise an installation location of an isolation transformer of lighting units of the airfield ground lighting.

According to an example embodiment of the third aspect, the installation location is an underground installation container of an isolation transformer.

According to an example embodiment of the third aspect, the current measurements are transmitted by the measurement devices continuously or periodically.

According to an example embodiment of the third aspect, at least one of the measurement devices is integrated to an isolation transformer of the lighting circuit.

According to an example embodiment of the third aspect, the location information comprises at least one of geographical coordinates of the measurement device at the airfield, a location of an isolation transformer container the measurement device is installed to, an identifier of the measurement device or an identifier of a component of the electrical system to which the measurement device is installed to.

According to an example embodiment of the third aspect, the method comprises performing, by the measurement devices, self-charge inductively from the one or more lighting circuits.

Many of the attendant features will be more readily appreciated as they become better understood by reference to the following detailed description considered in connection with the accompanying drawings.

### BRIEF DESCRIPTION OF THE DRAWINGS

The accompanying drawings, which are included to provide a further understanding of the example embodiments and constitute a part of this specification, illustrate example embodiments and together with the description help to explain the principles of the example embodiments. In the drawings:
FIG. 1 illustrates an example of an electrical system for airfield ground lighting.
FIG. 2 illustrates an example of a monitoring system configured to perform one or more example embodiments;
FIG. 3 illustrates an example of one or more inductive measurement devices connected to one or more primary circuits of an electrical system for airfield ground lighting according to an example embodiment;
FIG. 4 illustrates an example of a monitoring system comprising a plurality of measurement devices communicatively coupled with a computing device;
FIG. 5 illustrates an example of a process for fault detection in an airfield ground lighting circuit; and
FIG. 6 illustrates an example of a method for monitoring electrical system of airport ground lighting.

Like references are used to designate like parts in the accompanying drawings.

### DETAILED DESCRIPTION

Reference will now be made in detail to example embodiments, examples of which are illustrated in the accompanying drawings. The detailed description provided below in connection with the appended drawings is intended as a description of the present examples and is not intended to represent the only forms in which the present examples may be constructed or utilized. The description sets forth the functions of the example and a possible sequence of operations for constructing and operating the example. However, the same or equivalent functions and sequences may be accomplished by different examples.

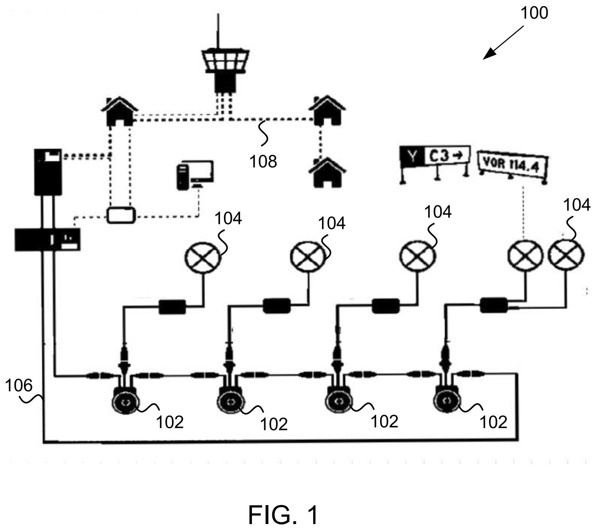

FIG. 1 illustrates an example of an electrical system 100 for airfield ground lighting. The electrical system 100 can comprise one or more lighting circuits 106. The lighting circuit 106 can comprise a plurality of protective separation transformers, e.g., isolation transformers 102. The isolation transformers 102 may be connected, for example, in series. Each isolation transformer 102 may be connected to one or more lights 104. The lights 104 may comprise, for example, stop bar lights, elevated lights, taxiway centerline lights, approach lights, and the like. Each lighting circuit 106 may have a plurality of lights, such as tens or even hundreds of lights 104. Although FIG. 1 illustrates one lighting circuit 106, the electrical system 100 can have hundreds of lighting circuits. The lighting circuits 106 may be coupled with other electrical circuits 108 associated with the airfield ground lighting. The electrical circuits 108 may be coupled with for example air traffic control, maintenance center, current control regulator, and other entities related to operations of airfield ground lighting.

Locating a fault in the electrical system 100 of airfield ground lighting may be cumbersome. The airfield can have lots of lighting circuits, cable distances are long, and the electrical equipment are typically installed underground. As a result, it can be hard to find and access the electrical equipment having a malfunction. Such electrical equipment can comprise cables, wirings, connectors, transformers, lighting units, and the like. Further, time windows for performing maintenance of the electrical equipment are typically narrow, such as two hours, because maintenance may not be performed during highly operative hours of a runway of the airfield. Usually, maintenance is performed at night when there is less air traffic.

An objective is to detect possible faults occurring at the electrical system of airfield ground lights. Further, locating the possible faults is made easier without requiring modifications to the associated electrical circuits, such as cutting cables to install monitoring devices. In addition, information about a state of the electrical system and environmental parameters of associated installation sites may be obtained to improve maintenance and other operations.

According to an example embodiment, faults are anticipated based on measured electrical changes in an electrical circuit, such as a lighting circuit of an airfield. At least part of transformers of the airfield, such as isolating transformers of the lights, are coupled with at least one measurement device comprising one or more current sensors. For example, the measurement device may comprise one or more current sensors configured to inductively monitor the current associated with a primary side of the transformer(s). For example, a pair of current sensors may be positioned around primary cables connected with the isolating transformer(s) such that one of the current sensors measure input current and one of the current sensors measure output current of the primary side. Alternatively, the measurement device may comprise a single current sensor, wherein the single current sensor is arranged to measure the current of the primary cables (e.g., an input and an output of primary conductor(s)) simultaneously. Hence, the single current sensor may detect when there is a difference in current between the primary cables, for example, when the measured current is above or below zero. As inductive measuring is used, the measurement devices are not part of the electrical circuit, but separate and externally mounted components. This enables, that the measurement devices can be retrofitted and can be used with equipment of different manufacturers and models. The measurement devices can be configured to transmit their measurement data wirelessly to a database for fault analysis. The measurement devices can further perform self-charging with the inductive components.

The transformers may be installed in different installation locations. The installation location may be, for example, an underground container for transformers such as a SIT (series isolation transformer) pit, a can, a mancave, or the like. The pit may be in a form of a concrete well. The concrete well may be a cylindrical container having one or more outlet tubes for cables towards the airfield lights coupled with the transformers installed inside the concrete well, as well as for cables feeding power to the transformers. In one example, the transformer housing may be a box mounted underground, for example, at a side of a runway.

Due to the underground mounting of the transformer housing, the installation locations of the transformers are prone to environmental factors and substances used at airports, such as to moisture, humidity, heat, ice, kerosene, antifreeze, defrosting liquids and the like. The electrical system of the airfield lighting may be further equipped with one or more sensor types configured to measure the environmental factors. Data provided by the one or more sensors can be used to estimate when a fault detected based on current measurements is caused, for example, by a broken electric equipment which needs to be replaced or by a temporary fault due to environmental factors. The data obtained from the one or more sensors may be also used to estimate priority of a detected fault.

Airfield ground lighting may be also referred to as airport ground lighting, aviation lighting, or simply airfield lighting. The airfield ground lighting is for guiding aircraft during landing, take-off, navigating in taxiways, and the like. In other words, inside lighting of airport buildings are out of scope of this disclosure.

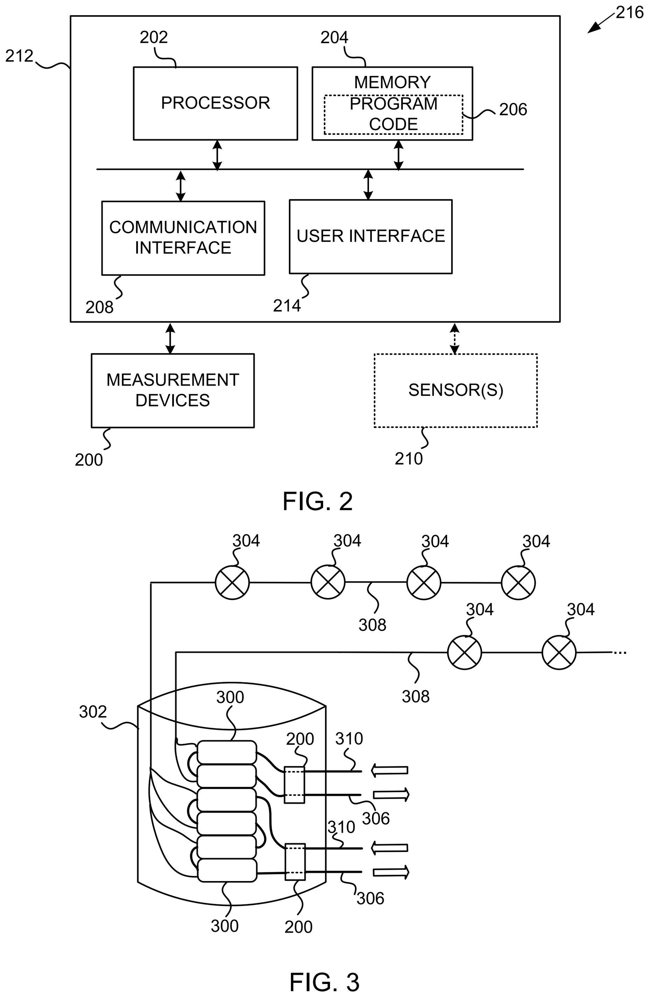

FIG. 2 illustrates an example embodiment of a monitoring system 216 configured to practice one or more example embodiments. The monitoring system 216 may be configured to monitor an electrical system of airfield ground lighting. The monitoring system 216 may comprise at least one measurement device 200. Preferably, the monitoring system 216 comprises a plurality of measurement devices 200. The monitoring system 216 may further comprise a computing device 212. The computing device 212 may be configured for fault detection based on current measurement data received from the measurement device(s) 200.

The computing device 212 may comprise at least one processor 202. The at least one processor 202 may comprise, for example, one or more of various processing devices, such as for example a co-processor, a microprocessor, a digital controller, a digital signal processor (DSP), a processing circuitry with or without an accompanying DSP, or various other processing devices including integrated circuits such as, for example, an application specific integrated circuit (ASIC), a field programmable gate array (FPGA), a microcontroller unit (MCU), a hardware accelerator, a special-purpose computer chip, or the like.

The computing device 212 may further comprise at least one memory 204. The memory 204 may be configured to store, for example, computer program code or the like, for example operating system software and application software. The memory 204 may comprise one or more volatile memory devices, one or more non-volatile memory devices, and/or a combination thereof. For example, the memory may be embodied as magnetic storage devices (such as hard disk drives, magnetic tapes, etc.), optical magnetic storage devices, or semiconductor memories (such as mask ROM, PROM (programmable ROM), EPROM (erasable PROM), flash ROM, RAM (random access memory), etc.).

When the computing device 212 is configured to implement some functionality, some component and/or components of the computing device 212, such as for example the at least one processor 202 and/or the memory 204, may be configured to implement this functionality. Furthermore, when the at least one processor 202 is configured to implement some functionality, this functionality may be implemented using program code 206 comprised, for example, in the memory 204.

In one example, the memory 204 may comprise program code 206 which, when executed by the at least one processor 202, causes the computing device 212 to monitor an electrical system. The electrical system may comprise one or more electrical circuits, such as a lighting circuit, with different components, such as for example lighting units, power sources, transformers, wiring, and/or electrical lines (e.g., cables). The computing device 212 may be configured to obtain current measurements of at least one lighting circuit from an installation location of measurement device 200. The measurement device 200 may comprise one or more sensors 210, wherein the one or more sensors 210 comprise at least a current sensor configured to measure current and/or changes in the current. The current sensor may be configured to measure the current without being physically connected with conductors to the electrical circuit. The current sensor may be a non-galvanic current sensor, a non-contact current sensor, or a non-invasive current sensor. A non-galvanic current measurement may not involve the direct flow of electrical current between the measuring instrument and the object or medium being measured. Non-galvanic current measurement may reduce interference, ensure safety and protect the lighting circuit. The non-galvanic current sensor may be for example an inductive sensor. For example, the measurement device 200 may be configured to be mounted on a cable of the lighting circuit (e.g., around the cable) such that the current sensor is capable of measuring the current flowing through the cable based on electromagnetic induction, capacitive coupling, optical isolation or radio frequency techniques. In one example, the current sensor may be a current transformer.

The measurement device 200 may comprise a pair of current sensors installed at different points of the lighting circuit of the electrical system to be monitored. The current sensors of the measurement device may measure changes in the current between the different points of the lighting circuit. For example, the pair of current sensors may be arranged to measure input current and output current of primary cables of a transformer or a set of transformers of a lighting circuit. The primary cables may be also referred to as a primary conductor, wherein the primary conductor has an input end and an output end with respect to the transformer or the set of transformers. In one example, the measurement devices 200 may comprise one current sensor instead of the two current sensors, and wherein the one current sensor is configured to measure the difference in current between the primary cable pair.

The computing device 212 may be configured to detect faults in the electrical system based on the current measurements received from the measurement devices 200. The computing device 212 be further configured to monitor environmental factors affecting the electrical system. The environmental factors may be monitored by the computing device 212 with one or more sensors 210. The one or more sensors 210 may therefore comprise environmental sensors configured to measure environmental parameters such as for example temperature, moisture, humidity, location, barometric pressure, acceleration and/or light. In one example, the monitored environmental factors may be used to detect a potential fault in the electrical system. In one example, in addition or alternatively, detected faults may be prioritized based on the monitored environmental factors. In one example, in addition or alternatively, the monitored environmental parameters may be used to determine if a fault in the electrical system is falsely detected. In one example, the one or more sensors 210 may be part of the measurement device(s) 200. Alternatively, the one or more sensors 210 are not part of the measurement devices 200, but external sensors communicatively coupled with the measurement device 200. The one or more sensors 210 may be configured to transmit their measurements to at least one measurement device 200. The at least one measurement device 200 may be configured to forward the measurements received from the one or more sensors 210 to the computing device 212.

As mentioned, the measurement device 200 may comprise at least one non-contact current sensor. The non-contact current sensors and the sensors 210 may be placed in an installation site of the electrical system. The used current and/or environmental sensor(s) may be positioned at an installation location of a transformer. In one example, the installation location may be an underground container enclosing a transformer. The transformer may be, for example, a series isolation transformer coupled with at least one lighting unit. Hence, the used sensors, and the measurement devices, may be installed to monitor the electrical system without a need to dig the ground and such that the wirings remain intact by installing them to the container housing the transformers and by using non-contact type of current sensors.

The computing device 212 may be configured to process signals received from the current sensors to detect changes in the current. The computing device 212 may determine whether the changes in the currents indicate that there is a leakage current. The computing device 212 may determine that there is a fault, e.g., a ground fault or an open circuit fault, in the electric system if the computing device 212 detects that there is a leakage current. Alternatively, the computing device 212 may determine that there is a fault when the computing device 212 detects that the leakage current exceeds a predetermined limit. The predetermined limit may be configurable and depend on the electrical system and/or electrical circuit being measured.

The computing device 212 may be further configured to process signals received from the environmental sensors to detect changes in the environmental parameters of the installation site. For example, the computing device 212 may detect that there is a fault or a hazard if the temperature measured by environmental sensors changes above or below a certain limit. An indication of a fault or a hazard may be also detected based on light detected by a light sensor. For example, the detected light may be indicative of an electric arc. Further, measures from the environmental sensors may be processed together with the measures received from the current sensors. For example, when there is no notable change in the measures received from the current sensors while light is detected by the light sensor, the detected light may be due to a poorly closed lid of a transformer container. The computing device 212 may be trained to analyse the data received from different types of sensors together such that a change in measurements from one sensor type can be classified as an indication of a fault or as a false indication of a fault based on concurrent data from another sensor type. When the detected change is classified as false indication, no further actions to address the detection may be initiated, or a notification about e.g., the possibly poorly closed lid may be transmitted to an operator.

Alternatively, the measurement device 200 may be configured to preprocess the signals received from at least one of the current sensors or the one or more sensors 210, and transmit the pre-processed data to the computing device 212 for analysis. For example, the measurement device 200 may organize the received measurements, label the measurements, add time information, or the like. In one example, the measurement device 200 may be configured to analyse the received measurements and transmit only measurements indicative of a change which may be caused by a fault in the electrical system. For example, the measurement device 200 may be configured to transmit the measurements when the received measurement is a certain percentage higher or lower than previous measurement(s) received from the respective sensor or in relation to other sensors of the same type and associated with the same electrical circuit. The measurement device 200 may be configured with one or more criteria for transmitting the received or performed measurements. In one example, the measurement device 200 may be configured to forward each signal received from the sensors to the computing device 212.

The computing device 212 may further comprise a communication interface 208 configured to enable the computing device 212 to transmit and/or receive information, such as the signals, or in general measurement data. The communication interface 208 may be configured to provide at least one wireless radio connection, such as for example a 3GPP mobile broadband connection (e.g. 3G, 4G, 5G). However, the communication interface 208 may be configured to provide one or more other type of connections, for example a wireless local area network (WLAN) connection such as for example standardized by IEEE 802.11 series or Wi-Fi alliance; a short range wireless network connection such as for example a Bluetooth, NFC (near-field communication), or RFID connection; a wired connection such as for example a local area network (LAN) connection, a universal serial bus (USB) connection or an optical network connection, or the like; or a wired Internet connection. The communication interface 208 may comprise, or be configured to be coupled to, at least one antenna to transmit and/or receive radio frequency signals. One or more of the various types of connections may be also implemented as separate communication interfaces, which may be coupled or configured to be coupled to a plurality of antennas.

The communication interface 208 may be configured to communicate with a plurality of measurement devices 200 and/or sensors 210. The computing device 212 may comprise a database. The database may be configured to gather measurement data obtained from measurement devices 200 and/or the sensors 210. The database may be configured to store and provide the information about the received measurements for fault analysis. The measurement device 200 may be configured to transmit messages to the database periodically. For example, the measurement device 200 may transmit messages at certain intervals and/or when the measurement device 200 receives a request to transmit messages. Alternatively, the measurement device 200 may transmit messages continuously. The messages may comprise for example data measured by the current sensors, the sensors 210 and/or a timestamp associated with the data. The measurement device 200 may be communicatively coupled with other apparatus(es), such as other measurement devices 200 or environmental sensors. The measurement device 200 may receive from the apparatus(es) data comprising measurements performed by the other apparatus(es) from other points of the electrical circuit, or from other electrical circuits, and transmit the data to the database.

Although the computing device 212 is illustrated as a single device it is appreciated that, wherever applicable, functions of the computing device 212 may be distributed to a plurality of devices.

The computing device 212 may further comprise other components and/or functions such as for example a user interface 214 comprising at least one input device and/or at least one output device. The input device may take various forms such a touch screen, or one or more embedded control buttons. The output device may for example comprise a display, a speaker, a vibration motor, or the like.

The functionality described herein may be performed, at least in part, by one or more computer program product components such as software components. According to an embodiment, at least one of the computing device 212 or the measurement device 200 comprises a processor or processor circuitry, such as for example a microcontroller, configured by the program code when executed to execute the embodiments of the operations and functionality described. Alternatively, or in addition, the functionality described herein can be performed, at least in part, by one or more hardware logic components. For example, and without limitation, illustrative types of hardware logic components that can be used include Field-programmable Gate Arrays (FPGAs), application-specific Integrated Circuits (ASICs), application-specific Standard Products (ASSPs), System-on-a-chip systems (SOCs), Complex Programmable Logic Devices (CPLDs), Graphics Processing Units (GPUs).

The monitoring system 216 comprises means for performing at least one method described herein. In one example, the means comprises the at least one processor, the at least one memory including program code configured to, when executed by the at least one processor, cause the monitoring system 216 to perform the method. At least one of the processors and/or memories may be comprised in at least one of the computing device 212 or the measurement device 200.

In one example, one or more inductive measurement devices 200 can be connected to one or more circuits of an electrical system for airfield ground lighting, as illustrated in FIG. 3. The circuit may be a lighting circuit 308 for an airfield ground lighting. The lighting circuit(s) 308 may comprise one or more lighting units 304. The lighting unit 304 may comprise at least one light, such as light 104. The lighting unit 304 may be coupled with a transformer 300, such as a series isolation transformer, configured to transform current of a primary circuit to a current value suitable for the light and fed from the transformer 300 via a secondary circuit for the lighting unit 304. The electrical system may be for example the electrical system 100 of FIG 1.

The measurement devices 200 may be installed at installation sites of electrical systems, such as airfield ground lighting systems. An installation site of an electrical system may comprise multiple installation locations. Usually, the measurement devices 200 are installed to underground installation locations, such as to a container, a tank, a casing, or the like designed to enclose and protect one or more components of the electrical system installed therein. The installation location may comprise one or more transformers 300, such as the series insulation transformers of the lights of the lighting circuit or of a plurality of lighting circuits.

In FIG. 3, two pairs of primary cables 306 are arranged to enter and leave an installation site, such as an installation container 302. The pair of primary cables include an input cable 310 and an output cable 306 of the primary circuit. Both the input and output cable 310, 306 may be installed to pass through the measurement device 200. The measurement device 200 may be configured to inductively measure leakage current of the primary circuit based on current changes occurring between the input and output cables 310, 306. In one example, the measurement device 200 may comprise one or more current transformers configured to perform measurements from the primary circuit. In one example, a the measurement device 200 may comprise a pair of current transformers, wherein the primary cable entering (input cable 310) the installation container 302 is arranged to pass through the first current transformer and the primary cable leaving (output cable 306) the installation container 302 is arranged to pass through the second current transformer. The measurement device 200 may be configured to compare the current values measured by the first current transformer and the second current transformer. If the measured current values are approximately the same, that is, there is no difference between the current readings, the measurement device 200 may conclude that there is no leakage current. On the other hand, when the measurement device 200 detects, based on the comparison, that there is an difference (e.g., X A - Y A = Z A, wherein X is a current value measured by the first current transformer and Y is a current value measured by the second current transformer) the measurement device 200 may conclude that there is leakage current in the respective lighting circuit 308. Optionally, cost-efficiency of the measurements can be improved by using a single current transformer configured to directly measure the current difference. For example, the current transformer may be mounted around both the input cable 310 and the output cable 306 such that any detected current value deviating from a zero value is indicative of a leakage current in the primary circuit. The measurement devices 200 may be also configured to store the measurements and provide the results to a remote device for analysis of the potential leakage current.

When the installation container 302 houses transformers of a plurality of lighting circuits 308, each of the primary cable pairs may be equipped a respective measurement device 200. In the example of FIG. 3, there are two pairs of primary cables 306, 310, wherein the first pair of primary cables form a first primary circuit feeding power to two transformers 300 connected in series via the first primary cables, and the second pair of primary cables form a second primary circuit feeding power to four transformers 300 connected in series via the second primary cables. Each of the primary circuits is equipped with a single measurement device 200 configured to inductive measure the current difference by comparing current values of the input and output primary cables of the respective primary circuit. Each of the transformers 300 feed power to the light of the lighting unit 304 of the respective lighting circuit 308. For example, the first primary circuit may comprise two transformers 300 configured to feed power to two lights via their secondary cables, and the second primary circuit may comprise four transformers 300 configured to feed power to four lights via their secondary cables. In one example, one or more measurement devices 200 may be integrated, for example, to one or more of the transformers 300.

Location of each measurement device 200 may be stored to a database. The location information may comprise, for example, an indication at which lighting circuit the measurement device 200 is located at, an indication in which underground transformer installation container 302 (or other installation location) the measurement device 200 is located at, and/or geographical coordinates of the installation location of the measurement device 200. Each measurement device 200 may be configured to measure current of a cable around which cable the measurement device 200 is mounted. However, depending on the type of the sensor used for current measurements, the measurement device 200 may be also installed e.g., on top of the cable or in vicinity of the cable. The current measurements may be performed, for example, inductively such the measurement device may be retrofitted to an existing circuit without needing to make changes to the circuit. This enables, that no cables need to be cut to install the measurement device 200, and no new components need to be added between the cables as part of the lighting circuit. Because the measurement devices 200 are installed to the installation location of the transformers, there is no need to dig the ground to gain access to the primary cables which would pose a risk of accidentally braking said cables.

In one example, the measurement devices 200 may be configured to transmit their current measurements to the database. In one example, the measurement devices 200 may be configured to measure the current and send the readings to the database at certain intervals. In one example, the certain interval may be 6 hours. However, the interval for transmitting the current readings is configurable, and can be less or more than the example value of 6 hours. The configured interval may depend on the installation location and/or measured lighting circuit. If a computing device (not shown in FIG. 3), such as computing device 212, configured to monitor the data stored in the database detects that a difference between current values measured by the measurement device 200 exceeds a configured limit, the computing device 212 may be configured to transmit or output (e.g., via an output device) a notification about the detected difference to maintenance. The transmitted notification may be given, for example, in a form of a text message or an email. The notification may comprise the location information of the measurement device 200. Alternatively, the notification may comprise an identifier of the respective measurement device 200, and the maintenance knows location of the measurement device 200 at the site based on the identifier. Alternatively, the measurement device 200 may be configured to perform the leakage current analysis itself and store the result. The measurement device 200 may be configured to transmit the result wirelessly to a remote device. The result may be transmitted in predetermined intervals or in response to a trigger. For example, the trigger may be detected leakage current or a wireless connection to a device configured to receive said measurements and/or indications of detected leakage currents. In one example, the computing device 212 may detect that there are changes in current values at multiple locations. The computing device 212 may determine a source location of the fault based on an installation location of the measurement device(s) 200 that indicate a greatest change in their current measurements.

Continuing with the previous example, the measurement device(s) 200 may be configured to measure temperature and current, and store the measurement data. The measurement device 200 may be further configured to transmit the measurement data to the database at certain intervals. The computing device 212 may be configured to monitor the received measurement data stored in the database. The computing device 212 may then detect that in one of containers the temperature is higher than in the other containers having corresponding measurement devices 200. When the temperature measured by the measurement device 200 located in said container exceeds a configured limit value, the computing device 212 may be configured to inform maintenance about the exceeded value. For example, the computing device 212 may provide, e.g., output, transmit, or cause transmission of information about the detected potential fault (e.g., exceeded temperature value) and an indication about a location of the potential fault. Indication of the location may comprise e.g., an identifier of the measurement device 200 which transmitted the respective temperature measurement or an identifier of the container where the measurement device 200 is located at when the identifier is linked with location information retrievable by the maintenance, or a location of the measurement device/container when stored at the computing device 212.

In one example, the measurement devices 200 may be configured to pre-analyse the received temperature measurements, and transmit a notification/warning at least one of to the computing device 212 or to the maintenance as soon as the measurement device 200 itself detects that the certain limit is exceeded. The temperature measurements may be analysed in conjunction with data received from other sensors, such as sensors 210, to estimate severity of the detected deviation. For example, the measurement device 200 may further comprise a light sensor. When an increased temperature reading is received from the temperature sensor simultaneously with a signal from the light sensor, this may indicate a fire inside the container. To ensure a fast reaction to the potential fire, the measurement device 200 may be configured to immediately transmit the warning. In one example, when there are multiple measurement devices 200 in one installation location, such as in a same container, it is sufficient that one of the measurement devices is equipped with one or more environmental sensor to obtain data for monitoring the environmental factors.

In another example, the environmental sensors may be configured to measure moisture level. The measurement device 200, or the computing device 212, may detect a potential fault, if the moisture level increases. However, during different seasons, moisture levels may differ. For example, during autumn, moisture level may be higher than during other seasons. The measurement device 200, or the computing device 212, may be configured to determine that there is not a fault, based on determining that the increased moisture level is related to environmental conditions of the season. The computing device 212 may further determine that a detected current change is related to the increased moisture level, for example, due to poorly made installations of the wires. The computing device 212 may anticipate problems in operation of the lighting circuits based on the detected increase in moisture level, and determine to inform maintenance about the detected increase in moisture level in the one or more locations..

Environmental sensors may be further configured to measure acceleration. When an aircraft is moving on the airfield, it creates vibrations that can be measured using acceleration sensors. The computing device 212 can be configured to provide information about detected traffic on the airfield to personnel of the airfield based on data received from the acceleration sensors.

Environmental sensors can be further configured to measure pressure to indicate weather conditions in installation location of the measurement device 200. For example, the computing device 212 may be configured to detect that the measurement device 200 or the installation location is under water based on sensor data received from the pressure sensor. The computing device 200 may further be configured to receive information indicative of weather conditions from a barometric pressure sensor. The computing device 200 may use the received information to evaluate if certain detected faults may be related to weather conditions and use the information to determine an urgency of the fault.

The computing device 212 can perform both short-term and longterm monitoring of potential faults in the electrical system. For example, depending on at least one of a magnitude of the detected current change(s) or a scale of the detected current changes, the computing device 212 can determine if the fault is urgent or not. When the fault is not urgent, and can be fixed by the maintenance for example within a time span of few years, the computing device 212 can keep monitoring on the current measurements and send a notification to the maintenance in case the situation gets worse and the current changes keep increasing or are detected in a wider area (e.g., from multiple measurement devices 200 located at different containers).

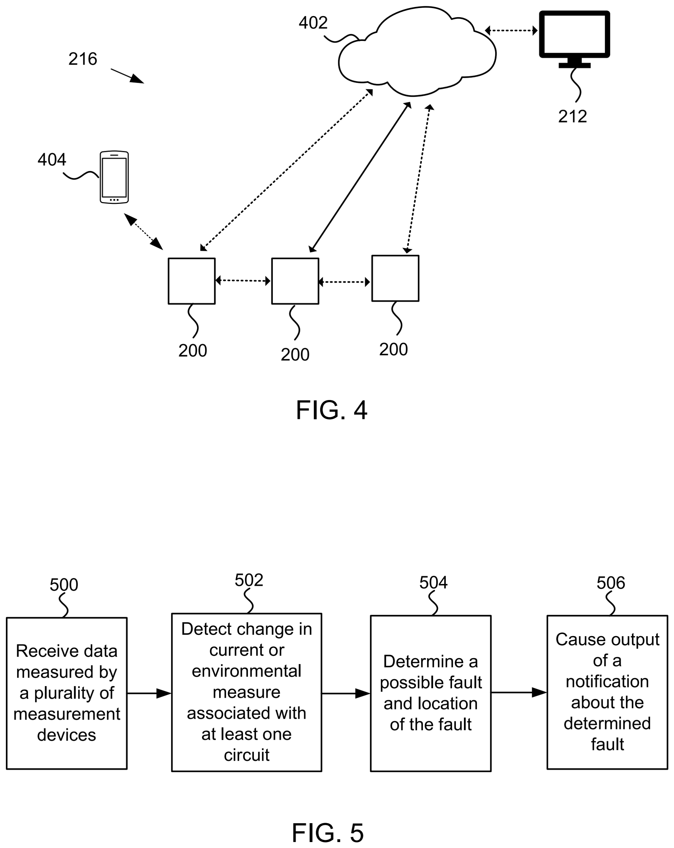

FIG. 4 illustrates an example of a monitoring system comprising a plurality of measurement devices 200 communicatively coupled with a computing device 212. The monitoring system 216 may be configured to monitor at least one of measured current and/or measured environmental parameters of one or more lighting circuits of an airfield.

In one example, all measurement devices 200 of a lighting circuit may be configured to transmit their measurement data according to stored instructions to a database. In one example, the database may be located in a cloud system 402. The computing device 212 may retrieve information stored in the database from the cloud system 402. Alternatively, the computing device 212 may be a server device comprised in the cloud system 402. The computing device 212 may thus be a remote device.

In one example, one measurement device 200 of the lighting circuit may be configured to operate as a master device. The master device may be configured to receive measurements performed by other measurement devices (slave devices). The slave devices may be configured to communicate with the master device, for example, via a Bluetooth connection or any other relative short distance communication means. The master device may be then configured to transmit both the received measurements and its own measurements to the database. That is, the measurement devices 200 may be configured to communicate with at least one of the database (e.g., a device storing said database) or with at least one other measurement device 200. Communication between the measurement devices and/or the device storing the database may be bidirectional. In one example, at least the master device may be installed closer to a ground level than other measurement devices of the circuit in order to improve reliability of the communication with the computing device 212 with improved signal strength.

In one example, at least one of the measurement devices 200, such as the master device, or all of the measurement devices 200 may be equipped with means for wireless communication, such as Bluetooth, and the measurement device(s) 200 may be configured to transmit the stored information to a user device 404. For example, a maintenance person may locally check the measurements obtained at an installation location of transformers by bringing their user device close to the installation location where the measurement device is installed and then receive the measurement data of the measurement device wirelessly by the user device 404. The maintenance person may then decide based on the received data if the installation location needs further inspection or maintenance.

FIG. 5 illustrates an example of a process for fault detection in an airfield ground lighting circuit. The process may be performed by a monitoring system 216 comprising one or more measurement devices 200. The monitoring system 216 may further comprise a computing device, such as computing device 212, configured to analyze measurement data obtained from the measurement devices 200. In one example, at least part of the analysis may be performed by one or more of the measurement devices 200 locally.

At 500, the monitoring system 216 may be configured to receive data measured by the plurality of measurement devices 200. The measurement data may comprise current values measured at different primary circuits of transformers associated with one or more airport lighting circuits. The measurement data may be indicative of current changes occurred at the respective primary circuits. The measurement data may further comprise data indicative of environmental factors, such as one or more measured environmental parameters.

At 502, the monitoring system 216 may be configured to detect a change in at least one of the current or environmental parameter associated with at least one airfield lighting circuit, wherein the change exceeds at least one preset threshold value. Different limits may be set to different airfield lighting circuits and/or different measured parameters. Further, different limits may be set to indicate an urgency of a possible detected fault. The change in current may be investigated by the monitoring system 216 with respect to current measurements received from measurement device(s) installed in one or more installation containers of the transformers of an airfield lighting system.

At 504, the monitoring system 216 may be configured to determine based on the detected change(s) and one or more respective thresholds if the detected change is indicative of a fault. The monitoring system 216 may be further configured to determine a location of the fault based on a location of the measurement device(s) 200 associated with the measurement data which lead to the detection of the fault. For example, the measurement data may comprise an identifier of the measurement device 200 from which measurement device the respective measurements were received from. Each identifier may be linked to location information at the airfield.

At 506, the monitoring system 216 may be configured to output, or cause output, of a notification about the determined fault. The notification may further comprise an indication of location of the fault, such as the identifier of the respective measurement device(s) or the associated location(s) at the airfield. Instead of the notification, information about the detected fault may be provided also in another suitable form, such as highlighted data shown on a display of a user device. The procedures of FIG. 5 may be performed, for example, by a control device, such as the computing device 212, of the monitoring system 216.

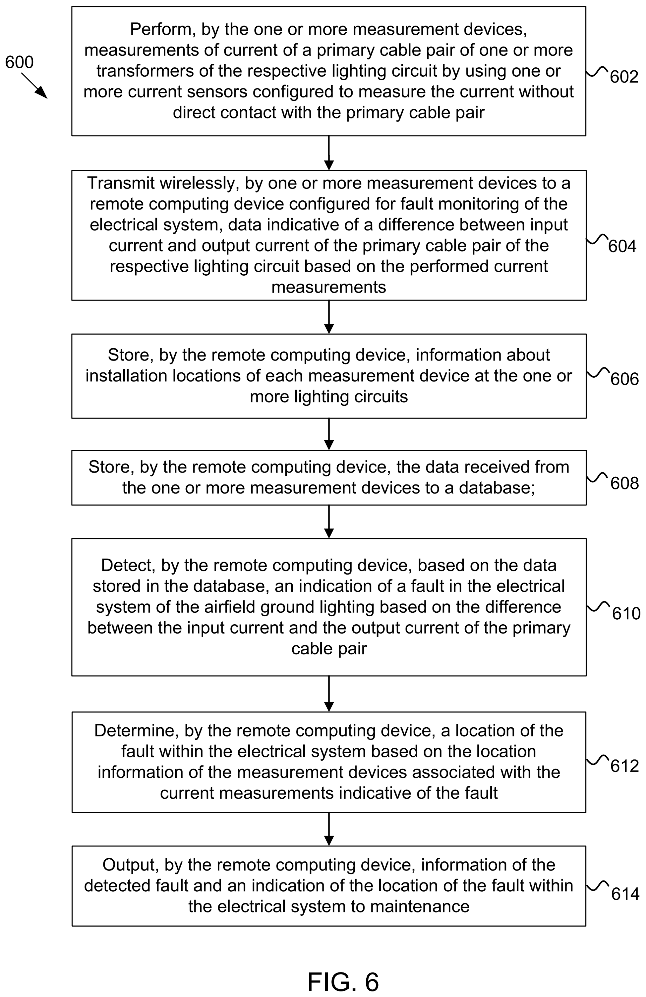

FIG. 6 illustrates an example of a method for monitoring electrical system of airfield ground lighting. The method may be performed by the one or more measurement devices being externally installed at one or more lighting circuits of the electrical system. External installation may mean that the measurement devices are not directly connected to a lighting circuit, e.g. between primary cables of transformer(s) the lighting circuit, but the measurement devices measure current of the lighting circuit such that the measurement devices are not part of the circuit but e.g. mounted around the cable(s) of the lighting circuit.

At operation 602, the method may comprise: performing, by the one or more measurement devices, measurements of current of a primary cable pair of one or more transformers of the respective lighting circuit by using one or more current sensors configured to measure the current without direct contact with the primary cable pair.

At 604, the method may comprise: transmitting wirelessly, by the one or more measurement devices to a remote computing device configured for fault monitoring of the electrical system, data indicative of a difference between input current and output current of the primary cable pair of the respective lighting circuit based on the performed current measurements.

At 606, the method may comprise: storing, by the remote computing device, information about installation locations of each measurement device at the one or more lighting circuits.

At 608, the method may comprise: storing, by the remote computing device, the data received from the one or more measurement devices to a database.

At 610, the method may comprise: detecting, by the remote computing device, based on the data stored in the database, an indication of a fault in the electrical system of the airfield ground lighting based on the difference between the input current and the output current of the primary cable pair.

At 612, the method may comprise: determining, by the remote computing device, a location of the fault within the electrical system based on the location information of the measurement device associated with the current measurements indicative of the fault.

At 614, the method may comprise: outputting, by the remote computing device, information of the detected fault and an indication of the location of the fault within the electrical system to maintenance.

It is obvious to a person skilled in the art that with the advancement of technology, the basic idea of the invention may be implemented in various ways. The invention and its embodiments are thus not limited to the examples described above, instead they may vary within the scope of the claims.

Further features of the methods directly result from the functionalities and parameters of the apparatus as described in the appended claims and throughout the specification and are therefore not repeated here. It is noted that one or more operations of the method may be performed in different order.

An apparatus may be configured to perform or cause performance of any aspect of the method(s) described herein. Further, a computer program may comprise instructions for causing, when executed, an apparatus to perform any aspect of the method(s) described herein. Further, an apparatus may comprise means for performing any aspect of the method(s) described herein. According to an example embodiment, the means comprises at least one processor, and memory including program code, the at one memory and the program code configured to, when executed by the at least one processor, cause performance of any aspect of the method(s).

Any range or device value given herein may be extended or altered without losing the effect sought. Also, any embodiment may be combined with another embodiment unless explicitly disallowed.

Although the subject matter has been described in language specific to structural features and/or acts, it is to be understood that the subject matter defined in the appended claims is not necessarily limited to the specific features or acts described above. Rather, the specific features and acts described above are disclosed as examples of implementing the claims and other equivalent features and acts are intended to be within the scope of the claims.

It will be understood that the benefits and advantages described above may relate to one embodiment or may relate to several embodiments. The embodiments are not limited to those that solve any or all of the stated problems or those that have any or all of the stated benefits and advantages. It will further be understood that reference to 'an' item may refer to one or more of those items.

The operations of the methods described herein may be carried out in any suitable order, or simultaneously where appropriate. Additionally, individual blocks may be deleted from any of the methods without departing from the scope of the subject matter described herein. Aspects of any of the embodiments described above may be combined with aspects of any of the other embodiments described to form further embodiments without losing the effect sought.

The term 'comprising' is used herein to mean including the method, blocks, or elements identified, but that such blocks or elements do not comprise an exclusive list and a method or apparatus may contain additional blocks or elements.

As used in this application, the term 'circuitry' may refer to one or more or all of the following: (a) hardware-only circuit implementations (such as implementations in only analog and/or digital circuitry) and (b) combinations of hardware circuits and software, such as (as applicable):(i) a combination of analog and/or digital hardware circuit(s) with software/firmware and (ii) any portions of hardware processor(s) with software (including digital signal processor(s)), software, and memory(ies) that work together to cause an apparatus, such as a mobile phone or server, to perform various functions) and (c) hardware circuit(s) and or processor(s), such as a microprocessor(s) or a portion of a microprocessor(s), that requires software (e.g., firmware) for operation, but the software may not be present when it is not needed for operation. This definition of circuitry applies to all uses of this term in this application, including in any claims.

As a further example, as used in this application, the term circuitry also covers an implementation of merely a hardware circuit or processor (or multiple processors) or portion of a hardware circuit or processor and its (or their) accompanying software and/or firmware. The term circuitry also covers, for example and if applicable to the particular claim element, a baseband integrated circuit or processor integrated circuit for a mobile device or a similar integrated circuit in server, a cellular network device, or other computing or network device.

It will be understood that the above description is given by way of example only and that various modifications may be made by those skilled in the art. The above specification, examples and data provide a complete description of the structure and use of exemplary embodiments. Although various embodiments have been described above with a certain degree of particularity, or with reference to one or more individual embodiments, those skilled in the art could make numerous alterations to the disclosed embodiments without departing from scope of this specification.

## Claims

1. A monitoring system (216) for electrical system of airfield ground lighting, comprising:
one or more measurement devices (200) externally mounted to one or more lighting circuits (308) of the electrical system such that the measurement devices (200) are not part of the lighting circuit (308), the one or more measurement devices (200) configured to:
perform measurements of current of a primary cable pair (306, 310) of one or more transformers (300) of the respective lighting circuit (308) by using one or more current sensors configured to measure the current without direct contact with the primary cable pair (306, 310); and
transmit wirelessly, to a remote computing device (212) configured for fault monitoring of the electrical system, data indicative of a difference between input current and output current of the primary cable pair (306, 310) of the respective lighting circuit (308) based on the performed current measurements;
the monitoring system (216) further comprising the remote computing device (212) configured to:
store information about installation locations of each measurement device (200) at the one or more lighting circuits (308);
store the data received from the one or more measurement devices (200) to a database;
detect, based on the data stored in the database, an indication of a fault in the electrical system of the airfield ground lighting based on the difference between the input current and the output current of the primary cable pair (306, 310);
determine a location of the fault within the electrical system based on the location information of the measurement devices (200) associated with the current measurements indicative of the fault; and
output information of the detected fault and an indication of the location of the fault within the electrical system to maintenance.

2. The monitoring system (216) of any preceding claim, wherein the fault is detected based on the difference exceeding a predefined threshold indicative of a leakage current.

3. The monitoring system (216) of any preceding claim, wherein the location of the fault is determined based on the installation locations of the measurement devices (200) associated with a greatest change in the difference indicated by the current measurements.

4. The monitoring system (216) of claim 1 or 2, wherein one or more of the measurement devices (200) further comprises one or more environmental sensors, and said measurement devices (200) are further configured to transmit, to the remote computing device, sensor data about one or more environmental factors associated with the installation location of the respective measurement device; and
wherein the remote computing device is further configured to detect, based on the received sensor data of the one or more environmental factors, at least one of an indication of a fault in the electrical system or an indication of an urgency of the fault.

5. The monitoring system (216) of claim 4, wherein the one or more environmental sensors are configured to monitor at least one of:
- temperature;
- humidity;
- location;
- pressure;
- barometric pressure;
- acceleration; and/or
- light.

6. The monitoring system (216) of any preceding claim, wherein a plurality of the measurement devices (200) is installed to the same installation location, and one of the plurality of measurement devices (200) is configured to receive the current measurements from the other measurement devices (200) of said installation location and to transmit the current measurements collectively to the computing device (212).

7. The monitoring system (216) of any preceding claim, wherein the one or more transformers (300) are isolation transformers (102) of lighting units (304) of the airfield ground lighting, and the installation locations comprise an installation location of the isolation transformers (102).

8. The monitoring system (216) of claim 7, wherein the installation location is an underground container for an isolation transformer (102).

9. The monitoring system (216) of any preceding claim, wherein the measurement devices (200) are configured to transmit the current measurements continuously or periodically.

10. The monitoring system (216) of any preceding claim, wherein at least one of the measurement devices (200) is integrated to an isolation transformer (102) of the one or more lighting circuits (308).

11. The monitoring apparatus of any preceding claim, wherein the location information comprises at least one of geographical coordinates of the measurement device (200) at the airfield, a location of an isolation transformer (102) pit the measurement device (200) is installed to, an identifier of the measurement device (200) or an identifier of a component of the electrical system to which the measurement device (200) is installed to.

12. The monitoring system (216) of any preceding claim, wherein the measurement device (200) is configured to perform self-charge inductively from the lighting circuits (308).

13. An electrical system of airfield ground lighting comprising the monitoring system (216) of any of claims 1 to 12.

14. A method for monitoring an electrical system of airfield ground lighting with one or more measurement devices (200) externally mounted to one or more lighting circuits (308) of the electrical system such that the measurement devices (200) are not part of the lighting circuit (308), the method comprising:
performing, by the one or more measurement devices (200), measurements of current of a primary cable pair (306, 310) of one or more transformers (102) of the respective lighting circuit (308) by using one or more current sensors configured to measure the current without direct contact with the primary cable pair (306, 310);
transmitting wirelessly, by the one or more measurement devices (200) to a remote computing device (212) configured for fault monitoring of the electrical system, data indicative of a difference between input current and output current of the primary cable pair (306, 310) of the respective lighting circuit (308) based on the performed current measurements;
storing, by the remote computing device (212), information about installation locations of each measurement device (200) at the one or more lighting circuits (308);
storing, by the remote computing device (212), the data received from the one or more measurement devices (200) to a database;
detecting, by the remote computing device (212), based on the data stored in the database, an indication of a fault in the electrical system of the airfield ground lighting based on the difference between the input current and the output current of the primary cable pair (306, 310);
determining, by the remote computing device (212), a location of the fault within the electrical system based on the location information of the measurement devices (200) associated with the current measurements indicative of the fault; and
outputting, by the remote computing device (212), information of the detected fault and an indication of the location of the fault within the electrical system to maintenance.
